# EUROPEAN PATENT SPECIFICATION

(11) **EP 0 845 681 B1**
(45) Date of publication and mention of the grant of the patent: **02.05.2003**
(21) Application number: 97309571.4
(22) Date of filing: 27.11.1997
(51) Int. Cl.: G01R 31/34, H02H 7/08

(54) **Electric motor monitoring arrangement**
Überwachung eines elektrischen Motors
Surveillance d'un moteur électrique

(30) Priority: 28.11.1996 GB 9624724
(43) Date of publication of application: 03.06.1998
(73) Proprietor: FR-HITEMP LIMITED, Wimborne, Dorset BH21 2BJ (GB)
(72) Inventor: Clarke, Alan, Gosport, Hants, PO12 2JH (GB); Clarke, Peter George, Locks Heath, Hants, SO31 6EL (GB); Ireland, Robert Sidney, Salisbury, Wiltshire, SP4 9DT (GB)
(74) Representative: Newell, William Joseph

(56) References cited:
- BE-A- 893 337
- DE-A- 3 228 954
- "Motor load detector" IBM TECHNICAL DISCLOSURE BULLETIN, vol. 28, no. 9, February 1986, ARMONK, NEW-YORK, USA, pages 3870-3871, XP002062410
- DATABASE WPI Section EI, Week 8805 Derwent Publications Ltd., London, GB; Class X13, AN 88-035606 XP002062411 & SU 1 320 859 A (LATV IND PROGRESS) , 30 June 1987

## Description

This invention relates to a monitoring arrangement for ensuring that an electric motor is operating normally. It particularly relates to motors used to drive fuel pumps, more particularly, fuel pumps used in aircraft.

Aircraft fuel pumps often rely on the flow of fuel being pumped for cooling. Fault situations can arise where the pump is operating but no fuel is flowing. For example, the pump might be running dry because the tank is empty, or the pump may have a jammed rotor, whereby the pump is energised and therefore dissipates energy but no fuel is pumped. The fact that the rotor is jammed does not necessarily mean that the pump is faulty, as the liquid being pumped may have solidified in the pump. The latter situation can arise when water is present in aviation fuel.

In such situations the lack of, or lack of flow of, coolant fuel can result in high motor temperatures, with consequential early failure and poor reliability performance. Even if the motor is fitted with a thermal protection device, by the time the protection devices operates, damage may already have been done to the pump motor.

Another situation which can arise is the occurrence of a short circuit or open circuit in one or more windings of the pump motor. In a pump operated from a three phase supply, a winding energised by one of the phases, or a conductor supplying one of the phases to the pump, may become open circuit. The pump may then continue to run, the current drawn by the two remaining phases increasing to compensate for the loss of the one phase, and pump performance is reduced. The consequential overload of the two functioning windings can lead to early failure of the pump.

A prior art proposal for detecting such faults is disclosed in German patent application DE3228954A1. This prior art proposal discloses an arrangement for monitoring a variable speed 3-phase asynchronous motor powered by a variable frequency AC supply from a variable frequency convertor. Monitoring is carried out on the conductors of the variable frequency supply.
The absolute currents of two of the three phase conductors are measured directly. The current in the first phase is determined directly using a first phase current transformer. The current in the second phase is determined directly using a second phase current transformer. The current in the third phase is determined indirectly by adding the currents of the other two phases.
A further current transformer is provided to monitor the actual instantaneous sum of the individual phase currents so as to detect any earth leakage current.
A voltage transformer is provided to determine the phase-phase voltage between two of the phase conductors. A DC voltage proportional to the instantaneous frequency of the variable frequency supply is obtained from the variable frequency convertor. This DC voltage is composed with a DC voltage proportional to the phase-phase voltage and used to determine the stalled rotor condition. Under the stalled rotor condition, the effective short circuit presented by the stalled rotor means that the output voltage of the variable frequency AC convertor drops to virtually zero.
The present invention arose in an attempt to provide an improved monitoring arrangement for three-phase motors.
The present invention provides a three phase electric motor monitoring apparatus comprising current measuring means for measuring the individual phase currents of each phase of the motor, and evaluation circuit means comprising phase current comparison means for determining the respective current differences between respective pairs of phase currents, reference condition means for providing a range of reference phase currents, reference means for providing a set of reference states, each state consisting of a range of phase current values determined by the reference phase currents and a set of current differences, each reference state representing a respective motor operating status, and means for correlating the respective individual phase currents and current differences with the set of reference states, thereby determining the actual operating state of the motor.

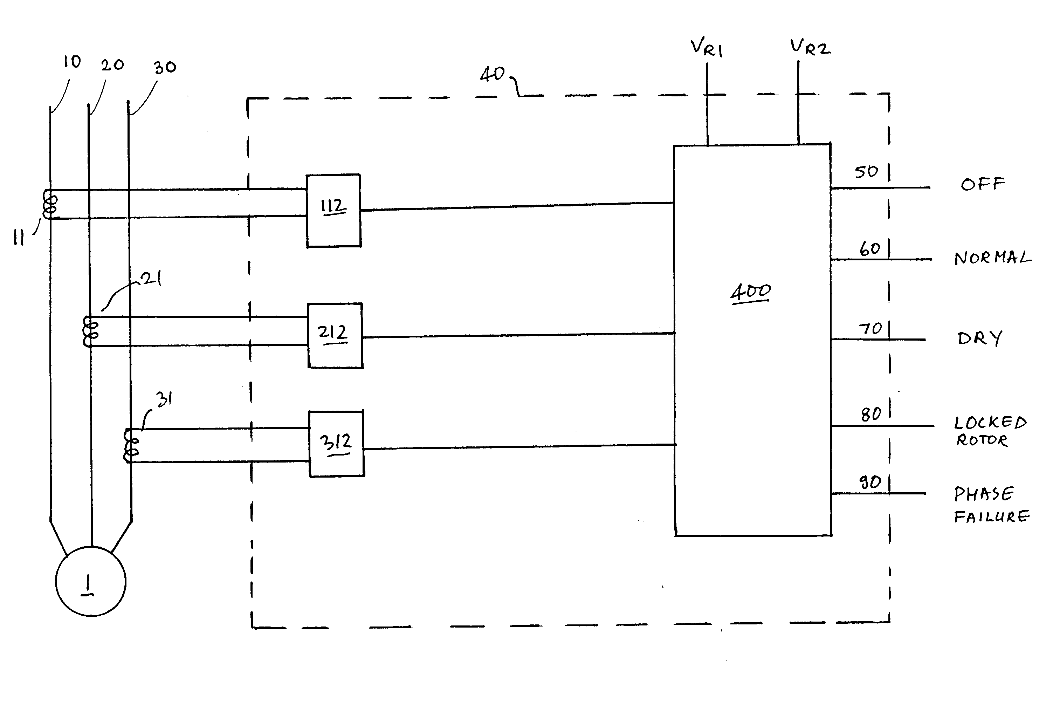

Referring to the drawing, a pump 1 is powered by 3-phase electricity supply via conductors 10, 20 and 30. Current monitoring sensors 11, 21 and 31 provide signals proportional to the respective currents flowing in the individual conductors 10, 20 and 30 to monitor circuit 40. Monitor circuit 40 is responsive to the individual currents in conductors 10, 20, 30 and has respective current to voltage convertors 112, 212, 312 to convert the sensed currents into voltages which are then fed to evaluation circuit 400.

Evaluation circuit 400 consists of a phase current comparison means for determining the respective current differences between respective pairs of phase currents, reference condition means for providing a range of reference phase currents, reference means for providing a set of reference states, each state consisting of a range of phase current values determined by the reference phase currents and a set of current differences, each reference state representing a respective motor operating status, and means for correlating the respective individual phase currents and current differences with the set of reference states, thereby determining the actual operating state of the motor.
Evaluation circuit 400 has threshold determining inputs V_{R1} V_{R2} which determine the limits of normal operation. An output signal is produced on one of output lines 50, 60, 70, 80, 90 according to the operating condition detected. An output on line 50 indicates the OFF state, line 60 the normal operating state, line 70 dry running pump, line 80 locked rotor, and line 90 phase failure.

In the present embodiment applicants found that the current drawn by each respective phase under normal operating conditions, I ₙₒₘ, lies within a first range of values and that the currents in the different phases are identical to within a few percent.

When the pump runs dry, then the greatly reduced mechanical resistance presented to the pump motor causes the current drawn to fall below the lower limit of the first range, the currents again being substantially equal for all phases. This lower current lies in a second band, I _{dry}.

If the pump stalls then the increased mechanical resistance presented to the pump motor causes the current to rise above the upper limit of the first range, the currents again being substantially equal for all phases. This high current lies in a third band I ₛₜₐₗₗ.

When the pump is turned off, the current in each phase is evidently zero. Again, current in all phases is substantially identical and is defined as I _{off}.

In the present embodiment the threshold for I_{off} is generated internally within the evaluation circuit 400 but may be provided by a further input in the manner of V_{R1},V_{R2}.

In the event of failure of the electricity supply to one winding of the pump motor, or an open-circuit in one winding, the current in the open-circuit line falls to zero while the current in the remaining two lines rises somewhat above the upper limit of the first range.

Typical results for an actual pump are tabulated below -

| Current Band | Current Range (A) | Pump Condition |
|---|---|---|
| I _{off} | <2A | Pump Off |
| I _{dry} | 2.5A - 4.5A | Pump Dry |
| I ₙₒₘ | 4.5A - 7.5A | Normal |
| I ₛₜₐₗₗ | >7.5A | Locked Rotor |
| Phase Failure | 1⌀<2A, 2⌀>4.5A | One Phase o/c |

It will be seen that the operating condition of the pump can be ascertained by simple comparison of the relative and absolute currents in the supply conductors.

A number of modifications are possible within the scope of the invention. The status-indicating signals on lines 50-90 can be utilised in a number of different ways according to operational requirements. Each line may be coupled to an individual indicator whereby the actual operational status of the pump is ascertainable.
Alternatively the signals may drive a suitable single indicator or display having a number of different possible display states or indications.
The outputs may be logically combined so as to drive a simple indicator which merely indicates if the pump is operating normally or not.
The outputs may be used to control a circuit breaker or the like instead of, or in parallel with, a display or indicator, whereby the pump is switched off if a status other than OFF or NORMAL exists.
The evaluation circuit 400 used to ascertain the absolute and relative currents may be analogue or digital or a combination of both.
Further threshold determining inputs may be provided to differentiate between different normal operating conditions and/or different fault conditions. At least some of the threshold determining inputs may be generated within the evaluation circuit instead of being generated externally.

## Claims

1. A three phase electric motor monitoring apparatus comprising current measuring means (11,112; 21, 212; 31, 312) for measuring the individual phase currents of each phase of the motor, and evaluation circuit means (400), said evaluation circuit means (400) comprising
phase current comparison means for determining the respective current differences between respective pairs of phase currents,
reference condition means for providing a range of reference phase currents,
reference means for providing a set of reference states, each state consisting of a range of phase current values determined by the reference phase currents and a set of current differences, each reference state representing a respective motor operating status, and means for correlating the respective individual phase currents and current differences with the set of reference states, thereby determining the actual operating state of the motor.

2. Apparatus as claimed in Claim 1 in which at least one reference state (60) represents normal operation and at least one further state (70, 80, 90) represents a fault condition status.

3. Apparatus as claimed in Claim 2 comprising cut-out means arranged to disconnect the motor on the determination of a fault condition status.

4. Apparatus as claimed in any preceeding claim in which the means for correlating comprises a plurality of outputs (50,60,70,80,90), each output corresponding to a respective operating status.

## Patentansprüche

1. Überwachungsvorrichtung für einen Drehstrommotor mit Strommeßmitteln (11, 112; 21, 212; 31, 312) zum Messen der Ströme der einzelnen Phasen des Motors und mit einem Bewertungsschaltkreis (400), wobei der Bewertungsschaltkreis (400) folgendes umfaßt:
Mittel zum Vergleichen von Phasenströmen, um jeweilige Unterschiede zwischen jeweils zwei Phasenströmen zu bestimmen,
Referenzbedingungsmittel, welche einen Bereich von Referenzphasenströmen zur Verfügung stellen,
Referenzmittel, welche einen Satz von Referenzzuständen zur Verfügung stellen, wobei jeder Satz von Referenzzuständen einen Bereich von Phasenstromwerten, die aus den Referenzphasenströmen bestimmt wurden, und einen Satz von Stromunterschieden umfaßt, wobei jeder Referenzzustand einen Betriebszustand des Motors repräsentiert.

2. Vorrichtung nach Anspruch 1, **dadurch gekennzeichnet, daß** wenigstens ein Referenzzustand (60) einen normalen Betriebszustand und wenigstens ein weiterer Zustand (70, 80, 90) einen Fehlerbedingungszustand repräsentiert.

3. Vorrichtung nach Anspruch 2, **dadurch gekennzeichnet, daß** ein Abschaltmittel vorgesehen ist, welches zum Abtrennen des Motors beim Feststellen eines Fehlerbedingungszustandes ausgebildet ist.

4. Vorrichtung nach einem der vorhergehenden Ansprüche, **dadurch gekennzeichnet, daß** das Mittel zum Korrelieren mehrere Ausgänge (50, 60, 70, 80, 90) aufweist, wobei jeder Ausgang einem jeweiligen Betriebszustand entspricht.

## Revendications

1. Appareil de surveillance d'un moteur électrique, triphasé comprenant des moyens (11, 112 ; 21, 212 ; 31, 312) de mesure de courant, pour mesurer les courants de phase individuels de chaque phase du moteur, et des moyens (400) de circuit d'évaluation, lesdits moyens (400) de circuit d'évaluation comprenant :
- des moyens de comparaison des courants de phase pour déterminer les différences de courant respectives entre des paires respectives de courants de phase ;
- des moyens de condition de référence pour fournir une gamme de courants de phase de référence ;
- des moyens de référence pour fournir un ensemble d'états de référence, chaque état consistant en une gamme de valeurs de courant de phase déterminées par les courants de phase de référence et un ensemble de différences de courant, chaque état de référence représentant un état de fonctionnement de moteur respectif et des moyens pour corréler les courants de phase individuels respectifs et les différences de courant avec l'ensemble d'états de référence, permettant ainsi de déterminer l'état réel de fonctionnement du moteur.

2. Appareil selon la revendication 1, dans lequel au moins un état de référence (60) représente un fonctionnement normal et au moins un autre état (70, 80, 90) représente un état de condition de défaillance.

3. Appareil selon la revendication 2, comprenant des moyens de coupe-circuit agencés pour déconnecter le moteur lors de la détermination d'un état de condition de défaillance.

4. Appareil selon l'une quelconque des revendications précédentes, dans lequel les moyens de corrélation comprennent une pluralité de sorties (50, 60, 70, 80, 90), chaque sortie correspondant à un état de fonctionnement respectif.
